Europäisches Patentamt

European Patent Office

Office européen des brevets

(11) Veröffentlichungsnummer: **0 395 160**
A1

## (12) EUROPÄISCHE PATENTANMELDUNG

(21) Anmeldenummer: **90201011.5**

(22) Anmeldetag: **23.04.90**

(51) Int. Cl.5: **H05K 7/16**

(30) Priorität: **27.04.89 DE 3913923**

(43) Veröffentlichungstag der Anmeldung:
**31.10.90 Patentblatt 90/44**

(84) Benannte Vertragsstaaten:
**DE ES FR GB IT NL SE**

(71) Anmelder: **Philips Patentverwaltung GmbH**
**Wendenstrasse 35 Postfach 10 51 49**
**D-2000 Hamburg 1(DE)**
(84) **DE**

Anmelder: **N.V. Philips' Gloeilampenfabrieken**
**Groenewoudseweg 1**

**NL-5621 BA Eindhoven(NL)**
(84) **ES FR GB IT NL SE**

(72) Erfinder: **Seitz, Reinhold, Dipl.-Ing. (FH)**
**Spindäckerstrasse 21**
**D-8501 Heroldsberg(DE)**
Erfinder: **Weidner, Hans-Jürgen**
**Krautäckerstrasse 28**
**D-8501 Winkelhaid(DE)**

(74) Vertreter: **Peuckert, Hermann, Dipl.-Ing. et al**
**Philips Patentverwaltung GmbH**
**Wendenstrasse 35 Postfach 10 51 49**
**D-2000 Hamburg 1(DE)**

(54) **Aufnahmevorrichtung für Baugruppen einheiten.**

(57)  1. Aufnahmevorrichtung für Baugruppeneinheiten.

2.1. Eine Aufnahmevorrichtung für Baugruppeneinheiten beispielsweise der Nachrichten- und Datentechnik soll bei möglichst geringem Platzbedarf die Befestigung sowohl einer einzelnen Baugruppeneinheit als auch die Befestigung weiterer Baugruppeneinheiten leicht ermöglichen.

2.2. Es wird vorgeschlagen, daß auf einer Grundplatte eine erste Baugruppeneinheit wahlweise parallel oder senkrecht zur Grundplatte befestigbar ist, wobei neben der ersten senkrecht zur Grundplatte befestigbaren Baugruppeneinheit mindestens eine weitere Baugruppeneinheit ebenfalls senkrecht zur Grundplatte anreihbar ist.

2.3. Aufnahmevorrichtungen für Baugruppeneinheiten der Nachrichten- und Datentechnik.

FIG. 1

EP 0 395 160 A1

## Aufnahmevorrichtung für Baugruppeneinheiten

Die Erfindung betrifft eine Aufnahmevorrichtung für Baugruppeneinheiten mit einer insbesondere an einer Wand befestigbaren Grundplatte.

Derartige Aufnahmevorrichtungen werden für Anlagen der Nachrichten- und Datentechnik benötigt. Eine an einer Grundplatte befestigbare Baugruppeneinheit besteht beispielsweise aus einer Steckaufnahme, in der mindestens eine Leiterplatte oder ein Steckeinschub angeordnet ist. Die Leiterplatte bzw. der Steckeinschub weisen an ihrem vorderen Rand Anzeige- und Bedienelemente und an ihrem rückwärtigen Rand Steckverbinderteile auf, die mit entsprechenden Gegensteckverbinderteilen kontaktierbar sind. Dabei sollen insbesondere beim Teilnehmer installierte Aufnahmevorrichtungen möglichst platzsparend an einer Wand befestigbar sein.

Der Erfindung liegt die Aufgabe zugrunde, eine Aufnahmevorrichtung der eingangs genannten Art anzugeben, die sowohl die Befestigung einer einzelnen Baugruppeneinheit bei möglichst geringem Platzbedarf als auch die Befestigung weiterer Baugruppeneinheiten ermöglicht und bei der darüber hinaus eine gute Zugänglichkeit zu den Baugruppeneinheiten gewährleistet ist.

Die Aufgabe wird bei einer Aufnahmevorrichtung der eingangs genannten Art dadurch gelöst, daß auf der Grundplatte eine erste Baugruppeneinheit wahlweise parallel oder senkrecht zur Grundplatte befestigbar ist, wobei neben der ersten senkrecht zur Grundplatte befestigbaren Baugruppeneinheit mindestens eine weitere Baugruppeneinheit ebenfalls senkrecht zur Grundplatte anreihbar ist.

Vorteilhafte Ausgestaltungsformen sind in den Unteransprüchen enthalten.

Anhand der in den Figuren schematisch dargestellten Ausführungsbeispiele soll die Erfindung näher erläutert werden.

Fig. 1 zeigt perspektivisch eine Aufnahmevorrichtung mit einer parallel zu einer Grundplatte angeordneten ersten Baugruppeneinheit.

Fig. 2 zeigt die Aufnahmevorrichtung der Fig. 1 mit zwei senkrecht zur Grundplatte angeordneten weiteren BaugrupPeneinheiten.

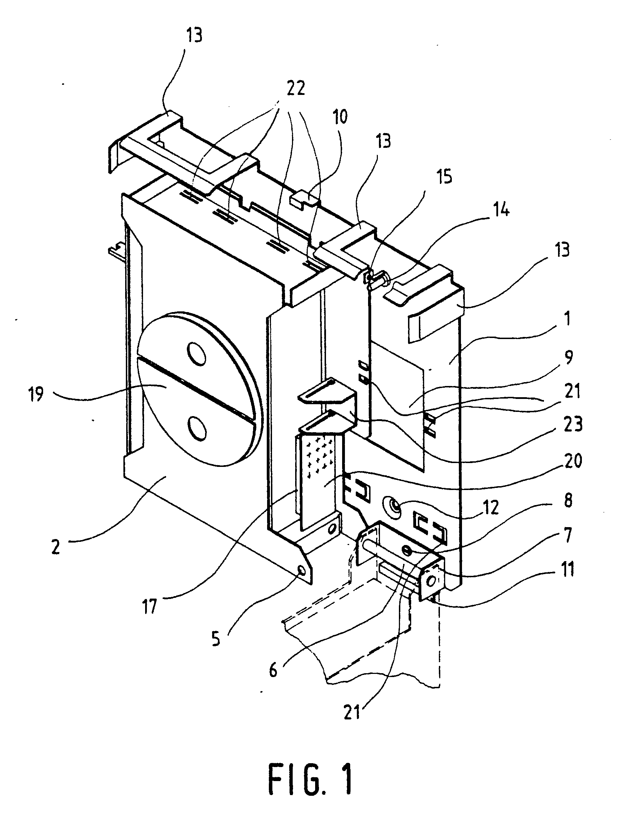

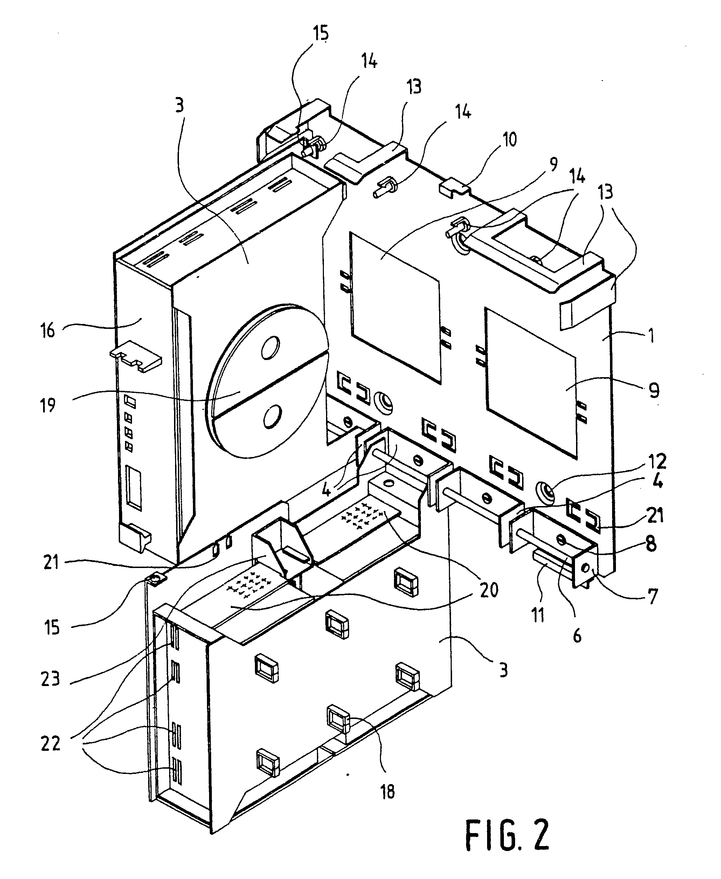

Die Figur 1 zeigt eine Aufnahmevorrichtung mit einer parallel zu einer Grundplatte 1 angeordneten ersten Baugruppeneinheit. Die Grundplatte 1 ist beispielsweise mit durch Anschraubbohrungen 12 hindurchführbaren, in der Figur nicht dargestellten, Schrauben, insbesondere an einer Wand, befestigbar. Die erste Baugruppeneinheit wird aus einer flachen, im wesentlichen kastenförmigen, Steckaufnahme gebildet, die beispielsweise durch Punktschweißen aus mehreren Blechteilen zusammengesetzt ist. In die Steckaufnahme 2 sind bestückte, in der Figur nicht dargestellte, Leiterplatten einsetzbar. Dazu weist die Steckaufnahme 2 an zwei gegenüberliegenden Schmalseiten Führungsnuten 22 auf, in welche die Leiterplatten einschiebbar sind. An der Rückseite der insbesondere als Doppeleuropakarte ausgebildeten Leiterplatte ist ein Vielfachsteckverbinderteil angeordnet, das beim Einstecken ein an der Rückseite der Steckaufnahme 2 auf einer Rückwandlei terplatte 20 angeordnetes Vielfachgegensteckverbinderteil 17 kontaktiert. An die Rückwandleiterplatte 20 sind Ansätze angeformt, die einerseits durch einen in der Steckaufnahme 2 angeordneten ersten Schlitz und andererseits durch einen weiteren Schlitz eines an der Steckaufnahme befestigbaren Teiles 23 hindurchgeführt sind. Anstelle der Leiterplatte im Doppeleuropakartenformat können auch zwei Einfacheuropakarten verwendet werden. Dazu werden an der Steckaufnahme 2 in den Figuren nicht dargestellte Zwischenführungen und eine mit Vielfachsteckverbinderteilen versehene weitere Rückwandleiterplatte 20 entsprechend angeordnet (Fig. 2).

Für besonders hohe Anforderungen an die Hochfrequenzdichtheit kann in der ersten Baugruppeneinheit 2 anstelle einzelner Leiterplatten ein als Steckeinschub ausgebildetes geschirmtes Gehäuse, beispielsweise aus Guß, untergebracht werden. In dem Gehäuse befindet sich dann ebenfalls eine Leiterplatte mit einem am rückwärtigen Rand angeordneten Vielfachsteckverbinderteil, das in das an der Steckaufnahme 2 angeordnete Vielfachgegensteckverbinderteil 17 einsteckbar ist. In der Fig. 1 nicht dargestellte Verbindungskabel zum Gegensteckverbinderteil 17 und gegebenenfalls zu weiteren an der Baugruppeneinheit angeordneten beispielsweise optischen Steckverbinderteilen sind aus der Wand kommend durch Ausschnitte 9 der Grundplatte 1 hindurchführbar. Zur Führung der Verbindungskabel ist die Grundplatte 1 mit Kabelbinderbefestigungen 21 und die Steckaufnahme 2 mit einer Aufnahme 19 für Kabelreserven oder mit Befestigungsbügeln 18 versehen (Fig. 2).

Die in der Fig. 1 dargestellte Aufnahmevorrichtung ist mit einer flachen Abdeckhaube versehbar. Die Abdeckhaube wird dazu von unten mit an ihrer Unterseite angeordneten Schlitzen in am Rand der Grundplatte 1 angeformte gewinkelte Ansätze 11 eingehängt und nach oben geklappt, so daß an den seitlichen Rändern und am oberen Rand der Grundplatte 1 angeformte Winkel 13 an der Abdeckhaube anliegen. Die Abdeckhaube weist eine in der Oberseite angeordnete Schließvorrichtung auf, die in einen am oberen Rand der Grundplatte 1 angeordneten Sperrwinkel 10 eingreift.

Die in der Fig. 1 dargestellte Aufnahmevorrichtung ermöglicht auf einfache Weise die Befestigung weiterer Baugruppeneinheiten. Dazu ist auf der Grundplatte 1 neben der ersten Baugruppeneinheit 2 ein erstes Scharnierteil 7 angeordnet, an dem die erste Baugruppeneinheit befestigbar ist. Das Scharnierteil 7 wird bei dem in den Figuren dargestellten Ausführungsbeispiel aus einem mittels einer Schraube 8 an die Grundplatte 1 anschraubbaren U-förmigen Winkel und einer Scharnierachse 6 gebildet, die beispielsweise mit Hilfe von Sprengringen gesichert ist. Die Steckaufnahme 2 der ersten Baugruppeneinheit ist an ihrer Rückseite im unteren Bereich mit Scharnierösen 5 versehen, die in etwa dem Durchmesser der Scharnierachse 6 entsprechen. Bei einer weiteren Ausgestaltungsform weist die Steckaufnahme 2 im Bereich der Scharnierösen 5 eine Scharnierachse auf, die in ein entsprechendes an der Grundplatte 1 befestigtes Scharnierteil einrastbar ist.

Soll an der in der Fig. 1 dargestellten Aufnahmevorrichtung mindestens eine weitere Baugruppeneinheit befestigt werden, so wird die erste Baugruppeneinheit 2 (= Steckaufnahme 2) von der Grundplatte 1 abgeschraubt, um 90° gedreht, so daß sie senkrecht zur Grundplatte 1 steht und die Scharnierösen 5 im Scharnierteil 7 entsprechend befestigbar sind. Die so befestigte, in der Fig. 1 gestrichelt dargestellte, erste Baugruppeneinheit 2 ist nach unten schwenkbar gelagert, so daß die zum Gegensteckverbinderteil 16 geführten Verbindungsleitungen beispielsweise für Servicezwecke gut zugänglich sind. An der den Scharnierösen 5 gegenüberliegenden Rückseite der ersten Baugruppeneinheit 2 ist eine Rastöffnung 15 angeformt, die beim Hochschwenken der Baugruppeneinheit 2 in ein auf der Grundplatte 1 angeordnetes Rastmittel 14 einrastet. Die Rastverbindung ist ohne besondere Hilfsmittel wieder lösbar und somit die einzelne Baugruppeneinheit nach unten klappbar. Bei einer vorteilhaften Ausgestaltungsform ist die Grundplatte 1 oder die Baugruppeneinheit 2 mit Dämpfungsmaterialien versehen, die beim Herunterklappen der Baugruppeneinheit 2 als Anschlag oder Abfangvorrichtung wirken.

Fig. 2 zeigt die Aufnahmevorrichtung der Fig. 1 mit zwei senkrecht zur Grundplatte 1 angeordneten weiteren Baugruppeneinheiten 3. Die Grundplatte 1 ist mit Anschraubbohrungen 12 für eine Wandmontage versehen. Neben dem ersten Scharnierteil 7 und der daran befestigbaren in der Fig. 2 nicht dargestellten ersten Baugruppeneinheit sind weitere Scharnierteile 4 zur Befestigung weiterer Baugruppeneinheiten 3 befestigt, die entsprechend der ersten Baugruppeneinheit als Steckaufnahme 3 ausgebildet sind und sowohl einzelne Leiterplatten als auch beispielsweise mit einer Frontplatte 16 versehene geschirmte Gehäuse aufnehmen können.

Die in den Figuren 1 und 2 dargestellte Aufnahmevorrichtung ermöglicht die Befestigung von insgesamt vier Baugruppeneinheiten, deren Rastöffnungen 15 beim Hochklappen der Baugruppeneinheiten in entsprechend auf der Grundplatte 1 angeordnete Rastmittel 14 einrasten.

Die in Fig. 2 dargestellte Aufnahmevorrichtung mit zwei Baugruppeneinheiten ist in dieser Ausbaustufe mit einer entsprechend den Abmessungen der Baugruppengehäuse ausgebildeten hohen Abdeckhaube versehbar, die vorteilhafterweise an der Frontseite eine Sichtfläche aufweist.

Die in den Figuren 1 und 2 dargestellte Aufnahmevorrichtung ist somit auf einfache Weise wahlweise platzsparend mit einer einzelnen Baugruppeneinheit oder mit bis zu vier Baugruppeneinheiten versehbar, wobei in beiden Fällen eine gute Zugänglichkeit zu den Verbindungsleitungen, insbesondere des Gegensteckverbinderteiles 17, gewährleistet ist.


**Ansprüche**

1. Aufnahmevorrichtung für Baugruppeneinheiten (2, 3) mit einer insbesondere an einer Wand befestigbaren Grundplatte (1),
dadurch gekennzeichnet,
daß auf der Grundplatte (1) eine erste Baugruppeneinheit (2) wahlweise Parallel oder senkrecht zur Grundplatte (1) befestigbar ist, wobei neben der ersten senkrecht zur Grundplatte (1) befestigbaren Baugruppeneinheit (2) mindestens eine weitere Baugruppeneinheit (3) ebenfalls senkrecht zur Grundplatte (1) anreihbar ist.

2. Aufnahmevorrichtung nach Anspruch 1,
dadurch gekennzeichnet,
daß an der Grundplatte (1) ein erstes Scharnierteil (7) angeordnet ist, an dem die erste Baugruppeneinheit (2) befestigbar ist und daß an der Grundplatte (1) weitere Scharnierteile (4) zur Aufnahme weiterer Baugruppeneinheiten (3) befestigbar sind.

3. Aufnahmevorrichtung nach einem der Ansprüche 1 oder 2,
dadurch gekennzeichnet,
daß die Scharnierteile (4, 7) jeweils eine Scharnierachse (6) aufweisen, die durch Scharnierösen (5) der Baugruppeneinheiten (2, 3) hindurchführbar ist.

4. Aufnahmevorrichtung nach einem der Ansprüche 1 bis 3,
dadurch gekennzeichnet,
daß auf der Grundplatte (1) Rastmittel (14) angeordnet sind, die in entsprechende Rastöffnungen (15) der Baugruppeneinheiten (2, 3) einrastbar sind.

5. Aufnahmevorrichtung nach einem der Ansprüche 1 bis 4,
dadurch gekennzeichnet,
daß die Baugruppeneinheiten (2, 3) eine Kabelaufnahmevorrichtung (18, 19) aufweisen.

6. Aufnahmevorrichtung nach einem der Ansprüche 1 bis 5,
dadurch gekennzeichnet,
daß die Grundplatte (1) zur Durchführung von Verbindungsleitungen Ausschnitte (9) aufweist.

7. Aufnahmevorrichtung nach einem der Ansprüche 1 bis 6,
dadurch gekennzeichnet,
daß die Baugruppeneinheiten (2, 3) als Steckaufnahme für einzelne Leiterplatten oder hochfrequenzdichte Gehäuse ausgebildet sind.

FIG. 1

FIG. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-B-1616794 (SIEMENS AG) <br> * Spalte 6, Zeile 57 - Seite 7, Zeile 21; Figur 4 * <br> --- | 1-4 | H05K7/16 |
| X | FR-A-647777 (ASSOCIATED TELEPHONE & TELEGRAPH COMPANY) <br> * Seite 2, Zeile 86 - Seite 3, Zeile 67; Figur 2 * <br> --- | 1-7 | |
| X | DE-U-8633756 (SIEMENS) <br> * das ganze Dokument * <br> --- | 1-6 | |
| X | DE-U-8800430 (SCLEICHER GMBH) <br> * das ganze Dokument * <br> ----- | 1, 7 | |

|  | RECHERCHIERTE SACHGEBIETE (Int. Cl.5) |
|---|---|
|  | H05K |

Der vorliegende Recherchenbericht wurde für alle Patentansprüche erstellt

| Recherchenort | Abschlußdatum der Recherche | Prüfer |
|---|---|---|
| DEN HAAG | 18 JULI 1990 | TOUSSAINT F.M.A. . |

EPO FORM 1503 03.82 (P0403)